# EUROPEAN PATENT APPLICATION

(11) **EP 4 576 581 A1**
(43) Date of publication of application: **25.06.2025**
(21) Application number: 24221984.8
(22) Date of filing: 20.12.2024
(51) Int. Cl.: H03M 1/06, H03M 1/56

(54) **ANALOG-TO-DIGITAL CONVERTER AND ANALOG-TO-DIGITAL CONVERTING METHOD**

(30) Priority: 22.12.2023 KR 20230189407; 24.07.2024 KR 20240097902
(71) Applicant: SK hynix Inc., Bubal-eub Icheon-si Gyeonggi-do 17336 (KR)
(72) Inventor: JEON, Jin Uk, 17336 Icheon-si, Gyeonggi-do (KR)
(74) Representative: Isarpatent

(57) **Abstract**

An ADC device includes: a comparator having first and second input terminals and an output terminal and being configured to compare an input signal input through the first input terminal with a reference voltage input through the second input terminal to output a comparison result value through the output terminal, the reference voltage being decreased by a preset value from a previous value in response to a clock signal; a counter configured to output a digital count value that increases each time the clock signal toggles; a register configured to latch the digital count value based on the comparison result value and generate a digital value corresponding to the input signal based on the latched digital count value; a blocking capacitor connected to the first input terminal and configured to transmit the input signal to the first input terminal; and a control circuit configured to generate the clock signal.

## Description

### FIELD

Embodiments of the present disclosure relate to an analog-to-digital converter and an analog-to-digital converting method.

### BACKGROUND

An analog-to-digital converter (ADC) is an electronic circuit for converting an analog electrical signal into a digital electrical signal. That is, the ADC may extract the amplitude of an analog signal at a preset cycle and quantize and convert the extracted analog signal into a digital signal.

Recently, as the amount of data to be processed in image processing devices has increased, it is necessary to have a large number of ADCs and operate at a high operating speed at the same time. To have a large number of ADCs, an area may increase significantly, and power consumption may increase when operating at a high operating speed.

### SUMMARY

Therefore, various embodiments of the present disclosure are directed to providing an analog-to-digital converter capable of reducing an area and reducing power consumption in an environment in which a plurality of analog-to-digital converters are required.

The objects of the present disclosure are not limited to the above-described objects, and other objects that are not described will be able to be clearly understood by those skilled in the art to which the present disclosure pertains from the following description.

According to various embodiments of the present disclosure, an analog-to-digital conversion device may include: a comparator having first and second input terminals and an output terminal and being configured to compare an input signal input through the first input terminal with a reference voltage input through the second input terminal to output a comparison result value through the output terminal, the reference voltage being decreased by a preset value from a previous value in response to a clock signal; a counter configured to output a digital count value that increases each time the clock signal toggles; a register configured to latch the digital count value based on the comparison result value and generate a digital value corresponding to the input signal based on the latched digital count value; a blocking capacitor connected to the first input terminal and configured to transmit the input signal to the first input terminal; and a control circuit configured to generate the clock signal.

According to various embodiments of the present disclosure, an analog-to-digital conversion device may include: a reference voltage generator configured to generate a reference voltage that decreases by a preset value from a previous value in response to a clock signal; a control circuit configured to generate the clock signal; and a plurality of analog-to-digital conversion circuits. Each of the plurality of analog-to-digital conversion circuits includes: a comparator having a first input terminal, a second input terminal, and an output terminal, and being configured to compare an input signal input through the first input terminal with the reference voltage input through the second input terminal to output a comparison result value through the output terminal; a counter configured to output a digital count value that increases each time the clock signal toggles; a register configured to latch the digital count value based on the comparison result value, and generate a digital value corresponding to the input signal based on the latched digital count value; and a first blocking capacitor having a first end connected to the first input terminal, and being configured to transmit the input signal to the first input terminal.

According to various embodiments of the present disclosure, a complementary metal oxide semiconductor (CMOS) image sensor may include: a pixel array including a plurality of pixels arranged corresponding to a plurality of rows and a plurality of columns; a row decoding circuit configured to select a row among plurality of rows, and control to output pixel signals through the plurality of columns; a reference voltage generator configured to generate a reference voltage that decreases by a preset value from a previous value in response to a clock signal; a control circuit configured to generate the clock signal; and a plurality of analog-to-digital conversion circuits assigned to the plurality of columns, respectively, and configured to generate, based on the reference voltage, digital values corresponding to pixel signals output through the plurality of columns. Each of the plurality of analog-to-digital conversion circuits includes: a comparator having a first input terminal, a second input terminal, and an output terminal, and being configured to compare a pixel signal input through the first input terminal with a reference voltage input through the second input terminal to output a comparison result value through the output terminal; a counter configured to output a digital count value that increases each time the clock signal toggles; a register configured to latch the digital count value based on the comparison result value, and generate a digital value corresponding to the pixel signal based on the latched digital count value; and a first blocking capacitor connected to the first input terminal, and configured to transmit the pixel signal to the first input terminal.

According to various embodiments of the present disclosure, an Analog Computing-in-Memory (ACiM) system may include: a memory array configured to store weight information for contact points of a plurality of rows and a plurality of columns; a plurality of digital-to-analog converters provided at an input terminal of each of the plurality of rows and configured to convert digital input signal of each of the plurality of rows into an analog input signal; a reference voltage generator configured to generate a reference voltage that decreases by a preset value from a previous value in response to the input of each clock signal; a control circuit configured to generate the clock signal; and a plurality of analog-to-digital conversion circuits provided in each of the plurality of columns and configured to convert an analog output signal of each of the plurality of columns into a digital output signal, the analog output signal of each of the plurality of columns being generated by physically multiplying the analog input signal of each of the plurality of rows and corresponding weight information and physically summing multiplying results of all rows for each of the plurality of columns. Each of the plurality of analog-to-digital conversion circuits includes: a comparator having a first input terminal, a second input terminal, and an output terminal, and being configured to compare an input signal input through the first input terminal with a reference voltage input through the second input terminal to output a comparison result value through the output terminal; a counter configured to output a digital count value that increases each time the clock signal toggles; a register configured to latch and store the digital count value based on the comparison result value and generate a digital value corresponding to the input signal based on the latched digital count value; and a first blocking capacitor having one end connected to the first input terminal and transmitting the input signal to the first input terminal.

### BRIEF DESCRIPTION OF THE DRAWINGS

FIG. 1 is a diagram showing a structure of an analog-to-digital conversion circuit according to an embodiment of the present disclosure.
FIG. 2 is a diagram for conceptually describing a correlated double sampling (CDS) method for sampling an analog input signal IN in the analog-to-digital conversion circuit, according to an embodiment of the present disclosure.
FIG. 3 is a signal timing diagram when sampling the analog input signal IN according to the CDS method in the analog-to-digital conversion circuit, according to an embodiment of the present disclosure.
FIG. 4 is a flowchart describing the correlated double sampling method for deriving one sampling result based on the analog-to-digital conversion circuit of FIG. 1.
FIG. 5 is a diagram showing the input signal IN and output OUT in FIG. 1, and a signal IN1 in which a DC component is removed from the input signal passing through a DC blocking capacitor.
FIG. 6 is a diagram showing a structure of an analog-to-digital conversion device provided with a plurality of analog-to-digital conversion circuits, according to an embodiment of the present disclosure.
FIG. 7 is a diagram showing an example in which the plurality of analog-to-digital conversion circuits of FIG. 6 are applied to an Analog Computing-in-Memory (ACiM) system.
FIG. 8 is a diagram showing an example in which the plurality of analog-to-digital conversion circuits of FIG. 6 are applied to a CMOS image sensor.

### DETAILED DESCRIPTION

Hereinafter, embodiments of the present disclosure will be described in detail with reference to the accompanying drawings so that those skilled in the art to which the present disclosure pertains may easily carry out the present disclosure. However, the present disclosure may be implemented in various different forms and is not limited to the embodiments described herein. In addition, in order to clearly describe the present disclosure in the drawings, components irrelevant to the description have been omitted, and throughout the specification, similar components have been denoted by similar reference numerals.

In addition, when a certain portion is described as "including" a certain component, this means further including another component rather than precluding another component unless especially stated otherwise.

The terms used in embodiments of the present disclosure are general terms that are currently widely used as much as possible while considering a function in the present disclosure, but this may be changed depending on the intention or cases of a technician who works in the art, the emergence of a new technology, or the like. In addition, in specific cases, there are terms arbitrarily selected by the applicant, and in this case, the meaning will be described in detail in the descriptions of the corresponding embodiments. Therefore, the terms used in the present embodiments should be defined based on the meanings of the terms and the overall contents of the present embodiments rather than simply the names of the terms.

In the embodiments of the present disclosure, terms including ordinal numbers such as first or second may be used to describe various components, but the components are not limited by the terms. The terms are used only for the purpose of distinguishing one component from another. For example, a second component may be referred to as a first component, and similarly, the first component may also be referred to as the second component without departing from the scope of the present disclosure. The term "and/or" includes a combination of a plurality of related listed items or any of the plurality of related listed items.

In addition, in the embodiments of the present disclosure, the singular expression includes the plural expression unless the context states otherwise.

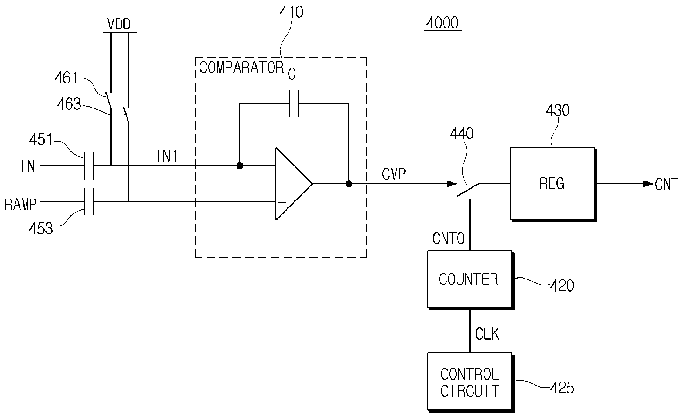

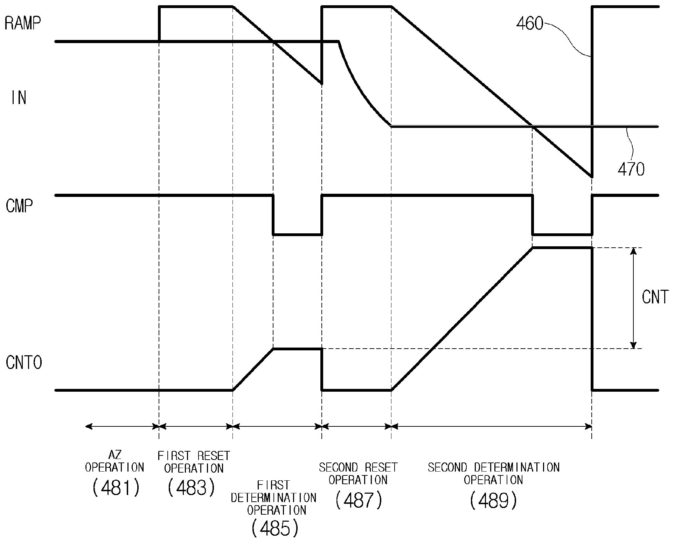

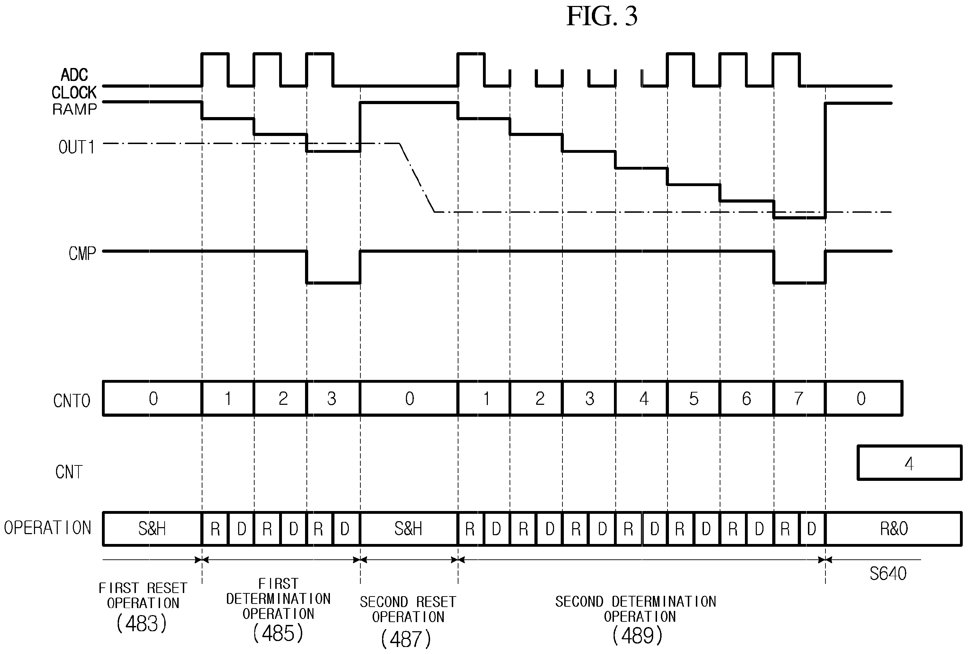

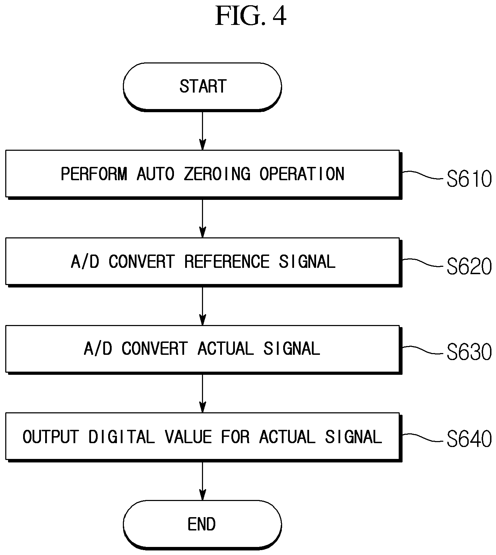

FIG. 1 is a diagram showing a structure of an analog-to-digital conversion circuit according to an embodiment of the present disclosure, FIG. 2 is a diagram for conceptually describing a correlated double sampling (CDS) method for sampling an analog input signal IN in the analog-to-digital conversion circuit, according to an embodiment of the present disclosure, FIG. 3 is a signal timing diagram when sampling the analog input signal IN according to the CDS method in the analog-to-digital conversion circuit, according to an embodiment of the present disclosure, and FIG. 4 is a flowchart describing the correlated double sampling method for deriving one sampling result based on the analog-to-digital conversion circuit of FIG. 1.

Referring to FIG. 1, an analog-to-digital conversion circuit 4000 may include a comparator 410, a counter 420, a control circuit 425, a register REG 430, and a switch 440. The analog-to-digital conversion circuit 4000 may further include DC blocking capacitors 451 and 453 and switches 461 and 463 connected to two input terminals of the comparator 410, respectively.

The DC blocking capacitors 451 and 453 can prevent a DC component from being transmitted to the inside of the analog-to-digital conversion circuit 4000 when an input signal has the DC component and allow the input signal to match an input range of the analog-to-digital conversion circuit 4000.

The switches 461 and 463 may apply a power supply voltage VDD to an input terminal of the comparator 410 during an initialization stage of the comparator 410 to maximally expand the input range of the comparator 410. The switches 461 and 463 may be connected during an auto zeroing (AZ) operation shown in FIG. 2 to initialize the comparator 410 and are not connected during a reset operation and determination operation to allow an analog input signal IN to be sampled to be input to the comparator 410.

The comparator 410 may include an operational amplifier (OP AMP) and a feedback capacitor Cf.

The comparator 410 may receive the analog input signal IN 470 to be sampled at one terminal and a ramp signal RAMP 460 applied from a ramp signal generator (not shown) at the other terminal and compare values of the two signals to output a comparison result signal CMP. Here, the ramp signal RAMP may be a reference voltage for comparison, and the ramp signal generator may also be referred to as a reference voltage generator. The comparison result signal CMP may be either '1' corresponding to a logic high level or '0' corresponding to a logic low level. In this case, since the ramp signal RAMP 460 is a signal of which a voltage level decreases (or increases) over time, a time when the values of the two signals input to the comparator 410 match occurs, and as the time point elapses, a value of the comparison result signal CMP output from the comparator 410 changes from a logic low level to a logic high level or vice versa.

The counter 420 may count a reference clock CLK from the time point when the ramp signal RAMP decreases (or increases) and output count value CNTO. At the time point when the value of the comparison result signal CMP output from the comparator 410 changes, the switch 440 may be operated, and as a result, the count value CNTO output from the counter 420 may be latched and stored in the register 430. In the configuration of FIG. 1, the comparison result signal CMP output from the comparator 410 is shown as turning the switch 440 on/off. According to another embodiment, the comparison result signal CMP output from the comparator 410 may function as an enable signal of the register 430, and the count value output from the counter 420 may be directly transmitted to the register 430. In addition, at the time point when the comparison result signal CMP is changed, the count value CNTO may be temporarily stored in the register 430 by the enable signal of the register 430. The count value stored in the register 430 may be output as a digital signal.

The control circuit 425 may generate and transmit a reference clock CLK to the counter 420. In addition, the control circuit 425 may control the on/off of the switches 461 and 463.

When a plurality of analog-to-digital conversion circuits are used, each analog-to-digital conversion circuit may have a different characteristic, and thus an unwanted offset may be added to the result of sampling. To compensate for the offset that may be included in the analog-to-digital conversion in this way, an analog input signal may be sampled using the CDS method as shown in FIG. 2.

Referring to FIG. 2, the CDS method may be an analog-to-digital conversion method that includes an auto zeroing (AZ) operation 481, a first reset operation 483, a first determination operation 485, a second reset operation 487, and a second determination operation 489.

In the CDS method, an operation for removing an offset that may be present in the comparator 410 during the auto zeroing operation 481 may be performed. To this end, the switches 461 and 463 of FIG. 1 may be turned on to connect the input terminal of the comparator 410 to the power supply voltage VDD.

During the first reset operation 483, the ramp signal RAMP may be boosted to rise to a preset voltage.

During the first determination operation 485, the analog input signal IN may be an analog signal in a reset state, and the ramp signal RAMP may be a voltage that drops at a constant slope from the preset voltage. The analog-to-digital conversion circuit 4000 may count the analog input signal IN in the reset state as a reference for removing noise included in the analog input signal IN and obtaining accurate data. The analog-to-digital conversion circuit 4000 may use, as a reference value, a value counted up to the time point when the comparison result signal CMP of the comparator 410 is converted during the first determination operation 485. The value counted during the first determination operation 485 may vary depending on the noise or offset included in the input signal IN.

When the comparison result signal CMP of the comparator 410 is converted, the second reset operation 487 may be performed to raise the ramp signal RAMP back to the preset voltage.

Then, during the second reset operation 487, the comparison result signal CMP of the comparator 410 may be converted back to a logic high level as shown in FIG. 2. During the second reset operation 487, the analog input signal may be released from the reset state and may be an actually measured value.

During the second determination operation 489, the analog input signal IN may be an actually measured value, and the ramp signal RAMP may be a voltage that drops at a constant slope from the preset voltage. During the second determination operation 489, the analog-to-digital conversion circuit 4000 may latch the value counted up to the time point when the comparison result signal CMP of the comparator 410 that compares the analog input signal IN with the ramp signal RAMP is converted. In addition, the final result may be a value obtained by subtracting the value counted during the first determination operation 485 from the value counted during the second determination operation 489.

Referring to FIG. 4, the analog-to-digital conversion circuit 4000 may perform the auto zeroing operation in operation S610. The analog-to-digital conversion circuit 4000 may turn the switches 461 and 463 of FIG. 1 on to connect the input terminal of the comparator 410 to the power supply voltage VDD for the auto zeroing operation of removing the offset that may be present in the comparator 410.

Referring to FIGS. 3 and 4, in operation S620, the analog-to-digital conversion circuit 4000 may perform analog-to-digital (A/D) conversion on the reference signal. To this end, the control circuit 425 of the analog-to-digital conversion circuit 4000 may turn the switches 461 and 463 of FIG. 1 off. According to an embodiment, the control circuit 425 may generate an offset detection control signal that controls a preset reference value to be applied to the input signal IN. According to one embodiment, the analog-to-digital conversion circuit 4000 may further include a reference value generator (not shown) for providing the preset reference value in response to the offset detection control signal. However, since the preset reference value is determined by a logic provided at a front end of the analog-to-digital conversion circuit 4000 for generating the input signal IN, according to another embodiment, the preset reference value may be generated by the logic provided at the front end of the analog-to-digital conversion circuit 4000 for generating the input signal IN.

The analog-to-digital conversion circuit 4000 may perform the first reset operation 483 and the first determination operation 485 to perform analog-to-digital conversion on the reference signal. During the first reset operation 483, the ramp signal RAMP may be output as a maximum value, and the analog input signal in the reset state, which is the reference signal, may be input as the analog input signal IN of the comparator. Here, the analog input signal in the reset state may be the maximum value of the analog input signal. During the first reset operation 483, the analog-to-digital conversion circuit 4000 may sample and hold (S&H) a signal that is input as an analog input signal IN1. The analog-to-digital conversion circuit 4000 may measure and hold a value of the analog input signal IN1 at the time point when the first reset operation 483 is performed and use the above value in the first determination operation 485. Therefore, even when the analog input signal IN1 is changed after sampling, the changed analog input signal may not affect the digital value to be converted.

The analog-to-digital conversion circuit 4000 may determine a digital conversion value for the reference signal in the first determination operation 485 of operation S620. During the first determination operation 485, as shown in FIG. 3, the counter 420 may output a count value CNTO that increases by 1 based on the reference clock CLK. In addition, the ramp signal RAMP may become a voltage that continuously decreases as much as a predetermined magnitude dV based on the reference clock CLK. The comparator 410 may output the comparison result signal CMP that compares the ramp signal RAMP with the analog input signal IN1 based on the reference clock CLK. The comparator 410 may output a logic high level as a result value when the ramp signal RAMP is greater than the analog input signal IN1 and output a logic low level as a result value when the ramp signal RAMP is less than the analog input signal IN1. The analog-to-digital conversion circuit 4000 may repeat the above operation until the comparison result signal CMP of the comparator 410 is changed from a logic high level to a logic low level.

When the result value of the comparator 410 becomes a logic low level, the analog-to-digital conversion circuit 4000 may latch and temporarily store the count value CNTO (e.g., 3) of the counter 420, finish the first determination operation 485, and proceed to operation S630.

In operation S630, the control circuit 425 of the analog-to-digital conversion circuit 4000 may generate a conversion control signal that controls the input signal IN to be converted into a digital value to be applied to the input signal IN. Therefore, the analog-to-digital conversion circuit 4000 may perform the second reset operation 487 and the second determination operation 489 to perform analog-to-digital conversion on the actually obtained analog signal. During the second reset operation 487, the ramp signal RAMP may be output as a maximum value, and the actual analog input signal may be input as the analog input signal IN1 of the comparator. According to one embodiment, the analog input signal IN1 may be a signal in which the DC component is removed by the DC blocking capacitor 451 from the actually obtained analog input signal IN.

During the second reset operation 487, the analog-to-digital conversion circuit 4000 may sample and hole (S&H) the signal that is input as the analog input signal IN1. The analog-to-digital conversion circuit 4000 may measure and hold a value of the analog input signal IN1 at the time point when the second reset operation 487 is performed and use the above value in the second determination operation 489. Therefore, even when the analog input signal IN1 is changed after sampling, the changed analog input signal may not affect the digital value to be converted. According to one embodiment, the operation of sampling and holding the signal may be performed by an external device for obtaining the analog input signal rather than the analog-to-digital conversion circuit 4000.

The analog-to-digital conversion circuit 4000 may determine a digital conversion value for the actually measured analog input signal IN1 in the second determination operation 489 of operation S630. During the second determination operation 489, as shown in FIG. 3, the counter 420 may output a count value CNTO that increases by 1 based on the reference clock CLK. In addition, the ramp signal RAMP may become a voltage that continuously decreases as much as a predetermined magnitude dV based on the reference clock CLK. The comparator 410 may output the comparison result signal CMP that compares the ramp signal RAMP with the analog input signal IN1 based on the reference clock CLK. The comparator 410 may output a logic high level as a result value when the ramp signal RAMP is greater than the analog input signal IN1 and output a logic low level as a result value when the ramp signal RAMP is less than the analog input signal IN1. The analog-to-digital conversion circuit 4000 may repeat the above operation until the comparison result signal CMP of the comparator 410 is changed from a logic high level to a logic low level. When the result value of the comparator 410 becomes a logic low level, the analog-to-digital conversion circuit 4000 may latch and temporarily store the count value CNTO (e.g., 7) of the counter 420, finish the second determination operation 489, and proceed to operation S640.

In operation S640, the analog-to-digital conversion circuit 4000 may output a difference between the digital value (e.g., 3) for the reference signal obtained and temporarily stored in operation S620 and the digital value for the actually obtained analog signal obtained in operation S630 as a final digital value OUT. In the example of FIG. 3, the analog-to-digital conversion circuit 4000 may output 4 obtained by subtracting 3 from 7 as the final digital value OUT.

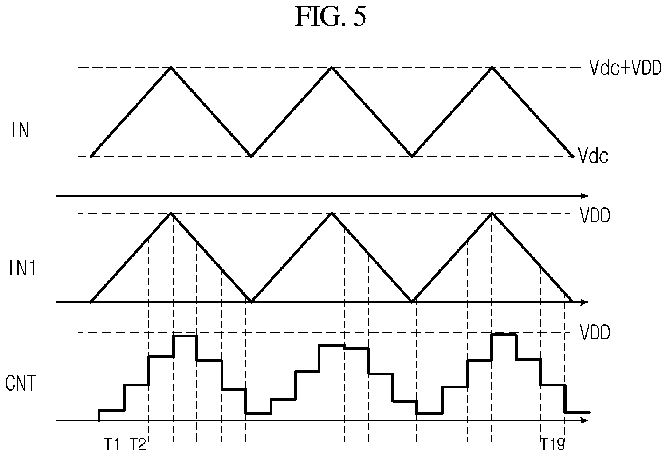

FIG. 5 is a diagram showing the input signal IN and output CNT in FIG. 1, and a signal IN1 in which a DC component is removed from the input signal passing through a DC blocking capacitor.

Referring to FIG. 5, the input IN may have a constant DC component Vdc. When such an input passes through the DC blocking capacitor 451, the DC component may be removed and only the analog signal IN1 may remain, and the analog signal IN1 may have a voltage between 0 V and VDD to match an input range of the comparator 410.

The signal input to the analog-to-digital conversion circuit 4000 may generate the output CNT according to the operating speed of the analog-to-digital conversion circuit 4000. Here, the output CNT may be a digital signal composed of a plurality of bits. When the operating speed is fast, the output may follow the analog input signal IN1 more precisely. In FIG. 5, the analog-to-digital conversion circuit 4000 described based on FIGS. 3 and 4 may be operated at each time section T1, T2, or T19 to provide the output OUT. As described above, the input signal IN may be sampled and held (S&H) at the start of each time section T1, T2, or T19 to prevent the influence of a change in input signal IN during the analog-to-digital conversion.

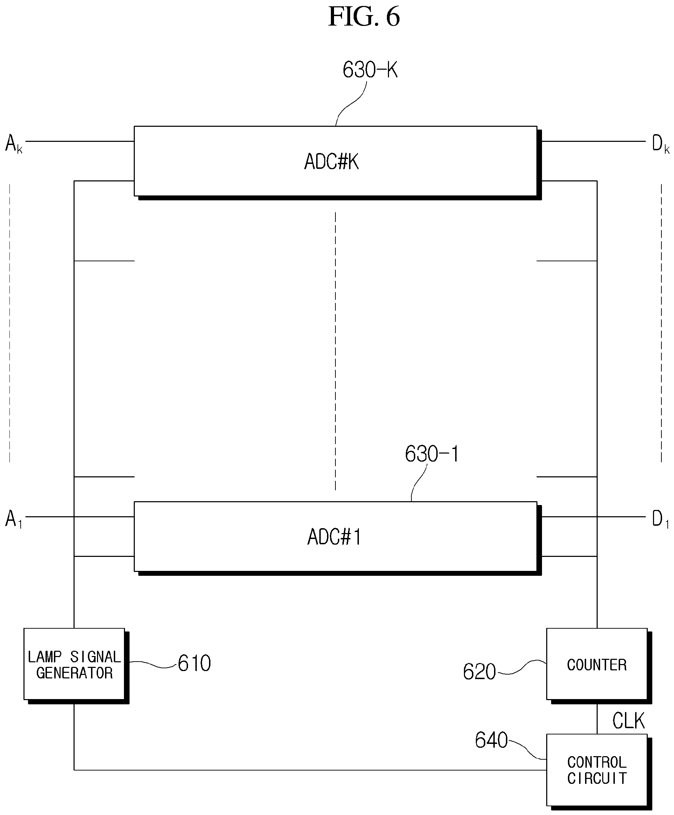

FIG. 6 is a diagram showing a structure of an analog-to-digital conversion device provided with a plurality of analog-to-digital conversion circuits, according to an embodiment of the present disclosure.

Referring to FIG. 6, a plurality of analog-to-digital conversion circuits (ADC#1 to ADC#K) 630-1 to 630-K may be provided in one chip or one device to process a large amount of data. In this case, each of the plurality of analog-to-digital conversion circuits 630-1 to 630-K may have a structure in which the counter 420 and the control circuit 425 are deleted from the analog-to-digital conversion circuit 4000 of FIG. 1. Alternatively, only one counter 620 may be provided outside the analog-to-digital conversion circuits 630-1 to 630-K as shown in FIG. 6 and connected to all the analog-to-digital conversion circuits 630-1 to 630-K to transmit the same count value to each of the analog-to-digital conversion circuits 630-1 to 630-K.

In addition, only one control circuit 640 may be provided outside the analog-to-digital conversion circuits 630-1 to 630-K as shown in FIG. 6 to provide the reference clock CLK to the counter 620 and may additionally control a ramp signal generator 610.

In addition, as shown in FIG. 6, the ramp signal generator 610 may be provided outside to provide the same ramp signal to all analog-to-digital conversion circuits 630-1 to 630-K.

The configuration of the plurality of analog-to-digital conversion circuits shown in FIG. 6 may be applied to an Analog Computing-in-Memory (ACiM) system, a CMOS image sensor, etc.

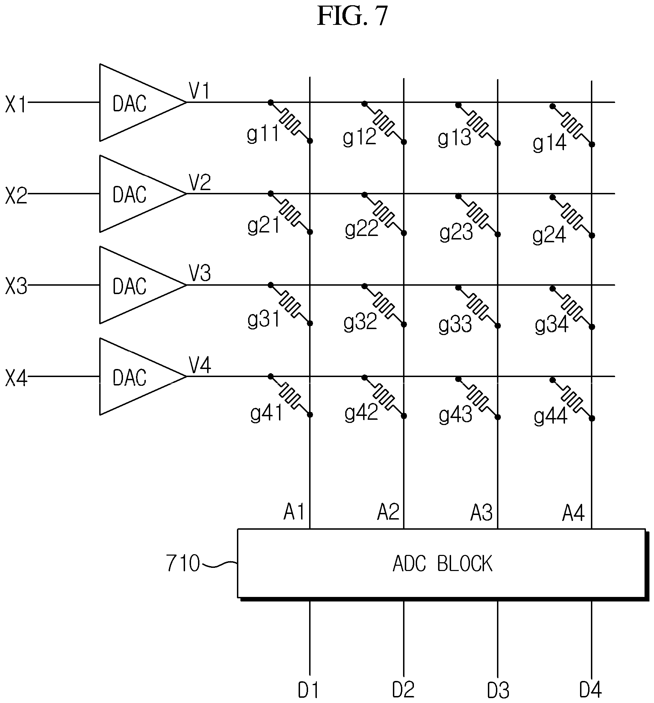

FIG. 7 is a diagram showing an example in which the plurality of analog-to-digital conversion circuits of FIG. 6 are applied to an ACiM system.

Referring to FIG. 7, the ACiM system may include a digital-to-analog converter (DAC) for converting digital input signals X1 to X4 into analog input signals V1 to V4 and an analog-to-digital converter (ADC) for converting internal calculation results A1 to A4 into digital output signals D1 to D4.

In addition, weights g11 to g44 may be stored as analog values in a memory or register of a node at which each row meets each column inside the ACiM system. The weights g11 to g44 may be conductance and may perform multiplication calculation on the applied analog input signals V1 to V4 to output a current. In addition, currents output from nodes of the same column may be added to become the internal calculation results A1 to A4 and input to an ADC block 710. Here, the ADC block 710 may be composed of a plurality of analog-to-digital conversion circuits as shown in FIG. 6. According to one embodiment, the internal calculation results A1 to A4 may be converted into voltages before being input to the ADC block 710.

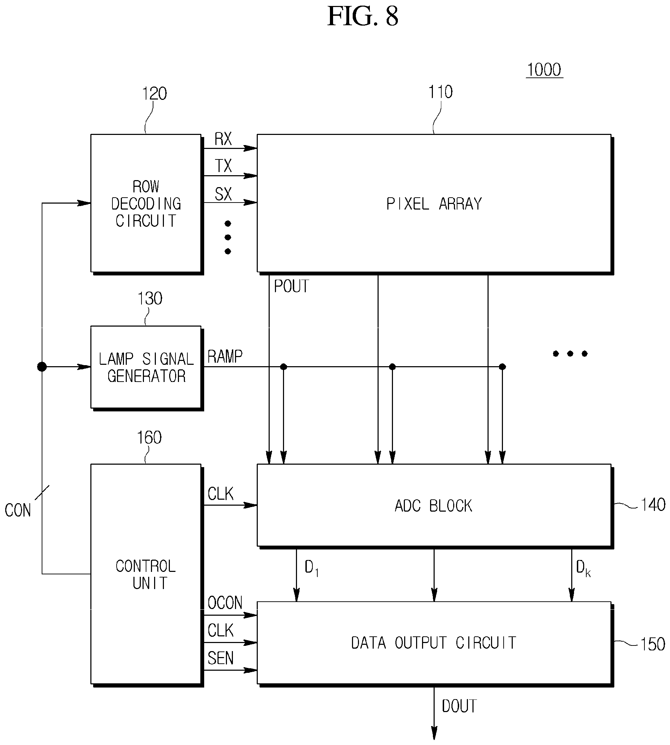

FIG. 8 is a diagram showing an example in which the plurality of analog-to-digital conversion circuits of FIG. 6 are applied to a CMOS image sensor.

Referring to FIG. 8, a CMOS image sensor 1000 may include a pixel array 110, a row decoding circuit 120, a lamp signal generator 130, an ADC block 140, a data output circuit 150, and a control unit 160. Here, the ramp signal generator 130 may be the same as the ramp signal generator 610 of FIG. 6, and the ADC block 140 may include the counter 620 of FIG. 6 and the plurality of analog-digital converter circuits 630-1 to 630-K. In addition, the control unit 160 may include the control circuit 640 of FIG. 6.

The pixel array 110 may include a plurality of pixels arranged in a matrix structure. The pixel array 110 may output an analog pixel signal POUT that converts an incident optical signal into an electrical signal, to the ADC block 140. Here, the pixel array 100 may be driven by driving signals such as a reset signal RX, a transmission signal TX, and a selection signal SX applied from the row decoding circuit 120.

The row decoding circuit 120 may select a row of the pixel array 110. That is, the row decoding circuit 120 may select pixels in the pixel array 110 by row according to a control signal CON applied from the control unit 160 and control its operation.

The ramp signal generator 130 may generate the ramp signal RAMP according to the control signal CON applied from the control unit 160. The ramp signal generated from the ramp signal generator 130 may be input to all analog-to-digital conversion circuits 630-1 to 630-K in the ADC block 140.

According to one embodiment, the ramp signal generator 130 may output the ramp signal RAMP of a voltage reduced by a predetermined value from the previous value when each clock is input in synchronization with the reference clock CLK. For example, a voltage of VDD-dV may be output during a clock cycle by a first clock, and a voltage of VDD-2dV may be output during the clock cycle by a second clock.

The ADC block 140 may convert the analog pixel signal POUT output from the pixel array 110 into a digital signal. Each of the analog-to-digital conversion circuits 630-1 to 630-K in the ADC block 140 may convert the analog pixel signal POUT into the digital signal according to the method described based on FIG. 3 or 4.

The ADC block 140 may compare the value of the pixel signal POUT output from the pixel array 110 with the value of the ramp signal RAMP applied from the ramp signal generator 130. The ADC block 140 may count the reference clock CLK applied from the control unit 160 in response to a comparison value of the pixel signal POUT and the ramp signal RAMP and output digital signals D₁ to D_{K} for the analog pixel signal POUT of each column.

The data output circuit 150 may latch the digital signals D₁ to D_{K} applied from the ADC block 140. The data output circuit 150 may latch count value and sequentially output pixel data DOUT in a digital format in response to an output control signal OCON and the reference clock CLK.

The control unit 160 may control the operations of the row decoding circuit 120, the ramp signal generator 130, the ADC block 140, and the data output circuit 150. According to one embodiment, the control unit 160 may include a timing generator, and using the timing generator, the control unit 160 may control all procedures from sensing an image to outputting sensed image data according to time information.

The control unit 160 may generate and output the control signal CON to the row decoding circuit 120 and the ramp signal generator 130. In addition, the control unit 160 may generate and output the reference clock CLK to the ADC block 140. In addition, the control unit 160 may generate and transmit the output control signal OCON, the reference clock CLK, and a sensing enable signal SEN to the data output circuit 150.

The control unit 160 may generate control signals that may convert signals received from pixels of the pixel array 110 into digital signals using the CDS method and control the ramp signal generator 130 and the ADC block 140.

As described above, the analog-to-digital conversion circuit proposed in the present disclosure may be used in the ACiM system or the CMOS image sensor and in particular, may be a dynamic comparator-based single slope analog-to-digital conversion circuit that is developed from a static comparator-based single slope analog-to-digital conversion circuit used in the conventional image sensors and operates according to a clock. Therefore, it is possible to reduce power consumed by the analog-to-digital conversion circuit, increase the operating speed, and make the implementation area smaller.

In addition, as shown in FIG. 7, the analog-to-digital conversion circuit may be used in the ACiM system, implemented in a smaller area than a successive approximation register (SAR) analog-to-digital conversion circuit used in the conventional ACiM system, and may significantly increase the operating speed.

In addition, the analog-to-digital conversion circuit according the embodiments of the present disclosure can solve the problem of mismatch in the operating range between the output of the ACiM system and the input of the comparator and maximally expand the input range of the analog-to-digital conversion circuit.

Although FIGS. 7 and 8 show an example in which the analog-to-digital conversion circuit is applied to the ACiM system or the CMOS image sensor, the application of the analog-to-digital conversion circuit is not limited thereto and may be used in all necessary electronic devices in the same or similar manner.

The implementation method of the analog-to-digital converter according to the embodiments of the present disclosure can be used to minimize the power consumption and areas of the analog-to-digital converters in products in which a plurality of analog-to-digital converters should be operated at the same time.

Although embodiments of the present disclosure have been described for illustrative purposes, those skilled in the art will appreciate that various modifications, additions and substitutions are possible, without departing from the scope and spirit of the disclosure. Therefore, the embodiments disclosed above and in the accompanying drawings should be considered in a descriptive sense only and not for limiting the technological scope. The technological scope of the disclosure is not limited by the embodiments and the accompanying drawings. The spirit and scope of the disclosure should be interpreted in connection with the appended claims and encompass all equivalents falling within the scope of the appended claims. Furthermore, the embodiments may be combined to form additional embodiments.

## Claims

1. An analog-to-digital conversion device comprising:
a comparator having a first input terminal, a second input terminal, and an output terminal, and being configured to compare an input signal input through the first input terminal with a reference voltage input through the second input terminal to output a comparison result value through the output terminal, the reference voltage being decreased by a preset value from a previous value in response to a clock signal;
a counter configured to output a digital count value that increases each time the clock signal toggles;
a register configured to latch the digital count value based on the comparison result value, and generate a digital value corresponding to the input signal based on the latched digital count value;
a first blocking capacitor having a first end connected to the first input terminal, and being configured to transmit the input signal to the first input terminal;
a first switch connected to the first input terminal, and configured to provide a power supply voltage to the first input terminal;
a second switch connected to the second input terminal, and configured to provide the power supply voltage to the second input terminal; and
a control circuit configured to generate the clock signal.

2. The analog-to-digital conversion device of claim 1, wherein the control circuit is further configured to generate the switch control signal to turn the first switch and the second switch on to perform an auto zeroing operation.

3. The analog-to-digital conversion device of claim 1, wherein the control circuit is further configured to generate an offset detection control signal that controls a preset reference value to be applied as the input signal, and
wherein the control circuit comprises a reference value generator connected to a second end of the first blocking capacitor, and configured to provide the preset reference value in response to the offset detection control signal.

4. The analog-to-digital conversion device of claim 3, wherein the register is configured to store a first digital count value obtained by latching the digital count value corresponding to the preset reference value.

5. The analog-to-digital conversion device of claim 4,
wherein the control circuit is configured to generate a conversion control signal that controls an analog signal to be converted to be applied as the input signal, and
wherein the register is further configured to generate the digital value by subtracting the first digital count value from a second digital count value obtained by latching a digital count value corresponding to the analog signal.

6. The analog-to-digital conversion device of claim 1, further comprising a reference voltage generator configured to generate the reference voltage.

7. The analog-to-digital conversion device of claim 6, further comprising a second blocking capacitor connected between the second input terminal and the reference voltage generator, and configured to transmit the reference voltage to the second input terminal.

8. The analog-to-digital conversion device of claim 1, wherein the comparator is further configured to:
output, as the comparison result value, a first value when the reference voltage is greater than the input signal; and
output, as the comparison result value, a second value different from the first value when the reference voltage is less than the input signal.

9. The analog-to-digital conversion device of claim 8, wherein the register is further configured to latch the digital count value when the comparison result value changes from the first value to the second value.

10. An analog-to-digital conversion device comprising:
a reference voltage generator configured to generate a reference voltage that decreases by a preset value from a previous value in response to a clock signal;
a counter configured to output a digital count value that increases each time the clock signal toggles;
a control circuit configured to generate the clock signal; and
a plurality of analog-to-digital conversion circuits,
wherein each of the plurality of analog-to-digital conversion circuits comprises:
a comparator having a first input terminal, a second input terminal, and an output terminal, and being configured to compare an input signal input through the first input terminal with the reference voltage input through the second input terminal to output a comparison result value through the output terminal;
a register configured to latch the digital count value based on the comparison result value, and generate a digital value corresponding to the input signal based on the latched digital count value; and
a first blocking capacitor having a first end connected to the first input terminal, and being configured to transmit the input signal to the first input terminal.

11. The analog-to-digital conversion device of claim 10,
wherein each of the plurality of analog-to-digital conversion circuits further comprises:
a first switch connected to the first input terminal, configured to provide a power supply voltage to the first input terminal; and
a second switch connected to the second input terminal, and configured to provide the power supply voltage to the second input terminal, and
wherein the control circuit is configured to generate a switch control signal that controls all first switches and second switches included in the plurality of analog-to-digital conversion circuits.

12. The analog-to-digital conversion device of claim 11, wherein the control circuit is further configured to:
generate the switch control signal to turn all the first switches and the second switches included in the plurality of analog-to-digital conversion circuits on to perform auto zeroing operations of the plurality of analog-to-digital conversion circuits;
generate the switch control signal to turn the first switch and the second switch off after a predetermined time, and generate an offset detection control signal that controls a preset reference value to be applied to the first input terminals of the plurality of analog-to-digital conversion circuits; and
generate a conversion control signal that controls a first input signal to be converted to be applied to the first input terminal after each of the plurality of analog-to-digital conversion circuits obtain a first digital count value for the preset reference value.

13. The analog-to-digital conversion device of claim 12, wherein the register included in each of the plurality of analog-to-digital conversion circuits is configured to:
store the first digital count value obtained by latching the digital count value corresponding to the preset reference value; and
generate the digital value by subtracting the first digital count value from a second digital count value obtained by latching a digital count value corresponding to the first input signal.

14. The analog-to-digital conversion device of claim 12, wherein the comparator included in each of the plurality of analog-to-digital conversion circuits is configured to:
output, as the comparison result value, a first value when the reference voltage is greater than the first input signal; and
output, as the comparison result value, a second value differing from the first value when the reference voltage is less than the first input signal.

15. The analog-to-digital conversion device of claim 14, wherein the register included in each of the plurality of analog-to-digital conversion circuits is configured to latch the digital count value when the comparison result value changes from the first value to the second value.
